# EUROPEAN PATENT APPLICATION

(11) **EP 0 581 420 A1**
(43) Date of publication of application: **02.02.1994**
(21) Application number: 93304113.9
(22) Date of filing: 27.05.1993
(51) Int. Cl.: H03K 19/177

(54) **Method and apparatus for providing a programmable interconnect path**

(30) Priority: 22.06.1992 US 902357
(71) Applicant: ADVANCED MICRO DEVICES, INC., Sunnyvale, CA 94088 (US)
(72) Inventor: Hoberman, Barry, Cupertino, California 95129 (US); Knecht, Marc W., Campbell, California 95088 (US)
(74) Representative: Wright, Hugh Ronald

(57) **Abstract**

In an integrated circuit, a low resistance programmable interconnect path is provided by using a higher voltage than the supply voltage to control the transistor switch elements used to form the programmable interconnect path. In one embodiment, the higher voltage is generated on-chip from the supply voltage using an oscillator circuit to drive a charge pump circuit, which includes MOS capacitors. The higher voltage is regulated by a voltage regulation circuit which limits the maximum value of the pumped voltage to a predetermined maximum, so as to enhance reliability of the integrated circuit.

## Description

This invention relates to integrated circuits, and in particular to integrated circuits commonly known as programmable logic devices.

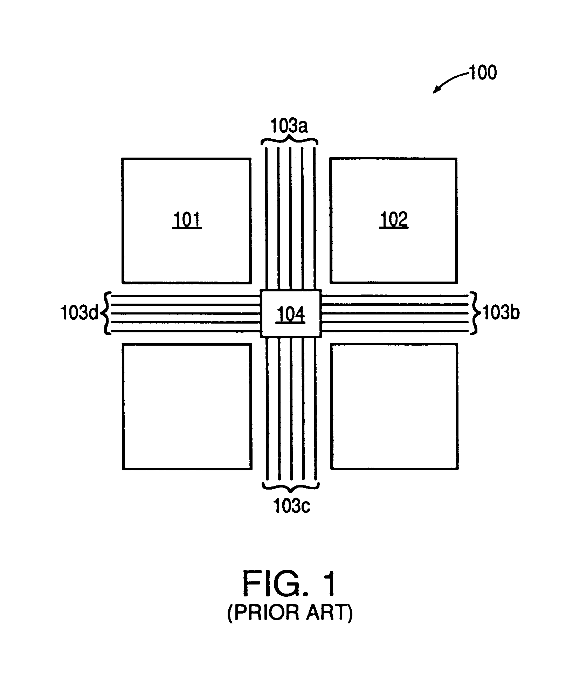

Figure 1 shows an example of a programmable logic device 100 in which blocks of logic circuits ("logic blocks") are interconnected by programmable interconnect elements ("programmable interconnect paths"). As shown in Figure 1, logic blocks 101 and 102 are interconnected by interconnect lines 103a, 103b, 103c and 103d located in "programmable routing channels". The connectivities in lines 103a-103d are determined by programmable switch element 104, which comprises a number of transistors and flip-flops. The flip-flops are also known as configuration memory bits or configuration RAM bits. One implementation of programmable switch element 104 is a cross-point switch element which allows connection of any of two lines in interconnect lines 103a-103d. Each possible connection ("connection point") is controlled by a configuration RAM bit in which is stored a value indicating whether a connection is to be made. Typically, the stored value of a configuration RAM bit provides a connection by selecting either a conducting or high-impedance state of a single transistor (e.g. an NMOS transistor) through a voltage applied at the transistor's gate terminal.

Some programmable logic devices allow the programmable interconnect paths to be "field programmable." Unlike factory-programmed devices, the field programmable logic devices are manufactured unprogrammed to allow the user the flexibility of programming at the time of use. In some instances, such programmable logic devices are provided to be "reprogrammable." As implied by its name, a reprogrammable logic device's connectivity can be modified during use.

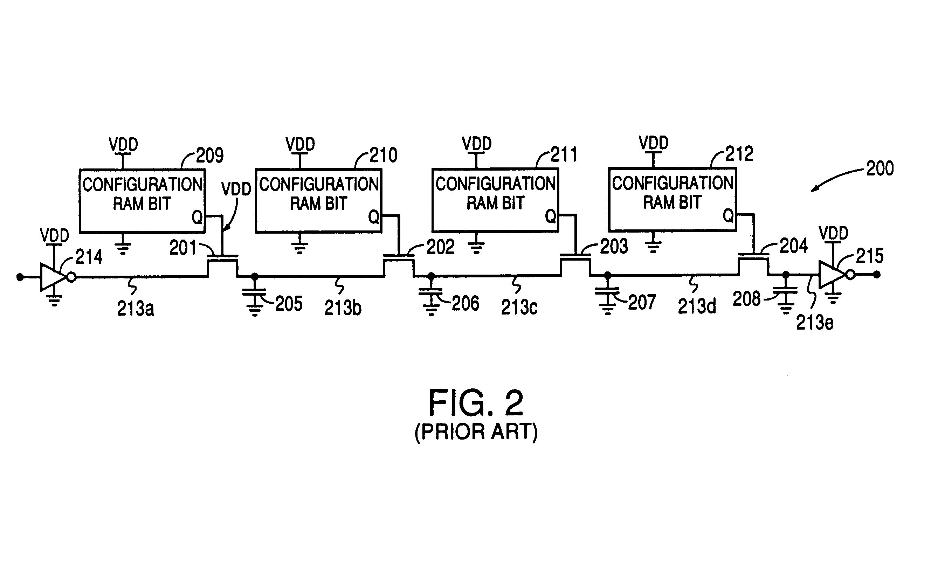

A programmable logic device, such as described above, comprises numerous logic blocks and programmable switch elements. Consequently, it is inevitable that some programmable interconnect paths may each comprise a large number of enabled transistors. Figure 2 shows an example of such a programmable interconnect path in programmable interconnect path 200. Interconnect path 200 is formed by storing "logic high" values in the configuration RAM bits 209-212, so as to place transistors 201-204 into their conducting states.

The parasitic capacitances in the interconnect lines 213a-d and the respective transistors 201-204 are represented in Figure 2 by capacitors 205-208. The combined effects of capacitors 205-208 and the "on-resistances" of transistors 201-204 adversely affect the signal rise and fall times attainable in programmable interconnection path 200, leading to performance degradation in the programmable logic device. It will be appreciated that the longer the interconnection path the more pronounced is the resulting performance degradation.

For a given supply voltage, the on-resistance of a transistor is determined by both the channel length and the channel width of the transistor. By first order approximation, on-resistance can be reduced by either shortening the channel length or widening the channel width. However, neither of these approaches to decrease on-resistance in a transistor is practical. This is because (i) the minimum channel length attainable is typically limited by the technology deployed in the manufacturing process, and (ii) a wider channel width results in a larger transistor. Such larger transistor leads to undesirable circuit density, lower manufacturing yield and higher cost.

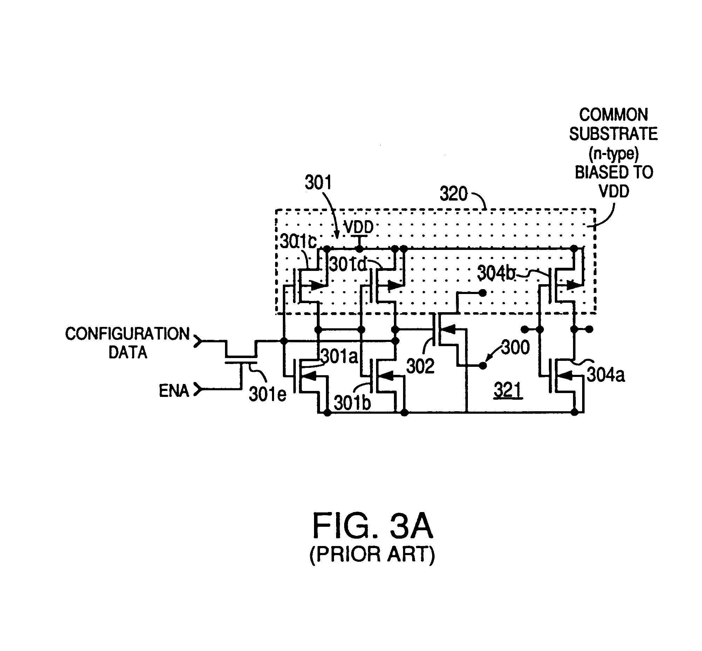

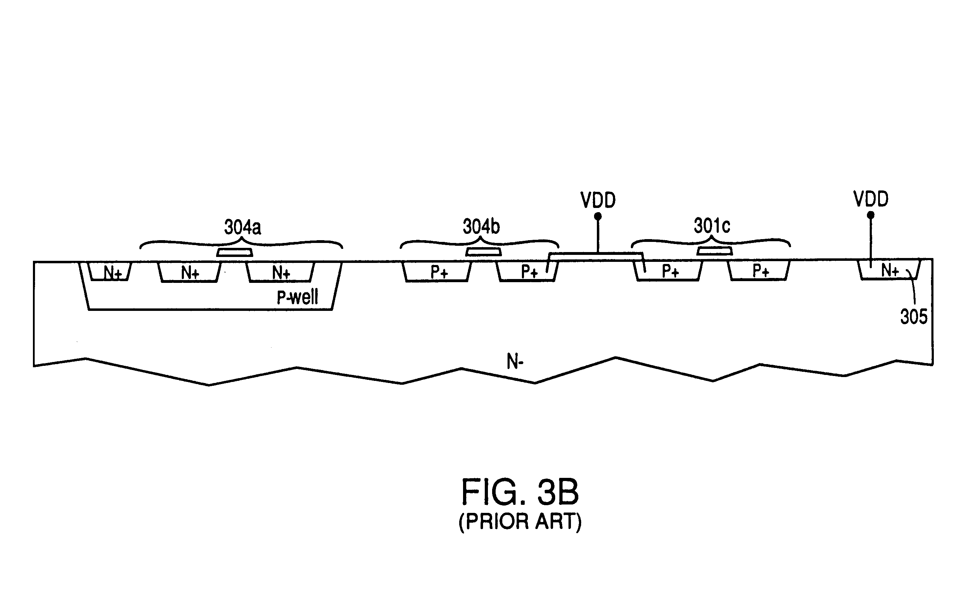

A CMOS implementation of the programmable logic device shown in Figures 1 and 2 can be implemented in a CMOS process using N- substrate and P-wells. Representative devices under this process are shown in Figures 3a and 3b. Figure 3a shows as an example one connection point of programmable interconnect path 300 having configuration RAM bit 301 formed by transistors 301a-301e for storing a 1-bit program which determines whether NMOS transistor 302 is conducting. NMOS transistor 302 is a switch providing a programmable connection in a programmable interconnect path for connecting interconnect lines, such as interconnect lines 103a-103d discussed above with respect to Figure 1.

Also shown in Figure 3a is inverter 304, including NMOS transistor 304a and PMOS transistor 304b. Inverter 304 is an inverter in a logic block, such as logic block 101 of Figure 1. As shown in shaded area 320, PMOS transistors 301c and 301d and PMOS transistor 304b are located in a connected portion 320 of N-substrate.

Figure 3b is an idealized cross section of one implementation of Figure 3a's connection point of programmable interconnect path 300, showing PMOS transistors 301cand 304b, and NMOS transistor304a in this circuit. As shown in Figure 3b, the source terminal of the PMOS transistor 301 and the source terminal of PMOS transistor 304b are provided the same supply voltage VDD. The N- substrate is also biased to supply voltage VDD via substrate contact 305.

We will describe a programmable interconnect path for interconnecting logic blocks of a programmable logic device formed by providing in the configuration RAM bits voltage VPP which has a voltage level higher than supply voltage VDD received in the logic blocks. By applying voltage VPP to a configuration RAM bit, a transistor controlled by the configuration RAM bit has a lower on-resistance. Consequently, the performance degradation experienced in a programmable interconnect path formed by a large number such transistors connecting in series is ameliorated due to the lower on-resistances.

In one embodiment of the present invention, voltage VPP is generated by a charge pumping circuit on-chip under control of a ring oscillator. In addition, a voltage regulation circuit is provided to disable the ring oscillator when the voltage VPP rises above a predetermined limit.

In one embodiment, the user can select whether to operate the programmable logic device with voltage VPP or without voltage VPP. When voltage VPP is disabled, the configuration RAM bits of the programmable interconnect paths operate at supply voltage VDD. A high voltage to low voltage converter provides the supply voltage VDD to terminals otherwise receiving voltage VPP.

In one embodiment implemented under a CMOS process, the PMOS transistors in the configuration RAM bits and the PMOS transistors in the logic blocks are formed on separate N-wells isolated by a P- substrate.

The present invention is better understood upon consideration of the following detailed description and the accompanying drawings.

### BRIEF DESCRIPTION OF THE DRAWINGS

Figure 1 shows programmable device 100 having logic blocks 101 and 102 interconnected by lines 103a-d through programmable switch element 104.
Figure 2 shows programmable interconnect path 200 formed by enabled transistors 201-204 having parasitic capacitance represented by capacitors 205-208.
Figure 3a shows exemplary devices in one connecting point in programmable interconnect path 300, including PMOS transistors 301 and 301 d of configuration RAM bit 301, and PMOS transistor 304b of inverter 304 in a logic circuit block, sharing the same N-substrate 320.
Figure 3b is an idealized cross section of one implementation of Figure 3a's connection point of programmable interconnect path 300 showing inverter 304 and PMOS transistor 301 c of configuration RAM bit 301.
Figure 4 shows exemplary devices of programmable interconnect path 400, including configuration RAM bits 405-408 and transistors 401-404; configuration RAM bits 405-408 each receive voltage VPP in accordance with the present invention.
Figure 5 shows one implementation of one connection point of programmable interconnect path 500, including PMOS transistors 501 and 501 d of configuration RAM 501, and PMOS transistor 503b of inverter 503; PMOS transistors 501c and 501 d, and PMOS transistor 503b are provided in separate N-wells 514 and 515, in accordance with the present invention.
Figure 6 is an idealized cross section of one implementation of Figure 5's connection point of programmable interconnect path 500, showing N-wells 514 and 515 biased by the voltage VPP and supply voltage VDD respectively; N-well 514 encloses PMOS transistors 501c and 501d in a configuration RAM cell 501 and N-well 515 encloses PMOS transistor 503b of inverter 503 in a logic circuit block.
Figure 7 is a schematic diagram of circuit 700 for providing voltage VPP in a programmable logic device, in accordance with the present invention.

### DETAILED DESCRIPTION OF THE PREFERRED EMBODIMENTS

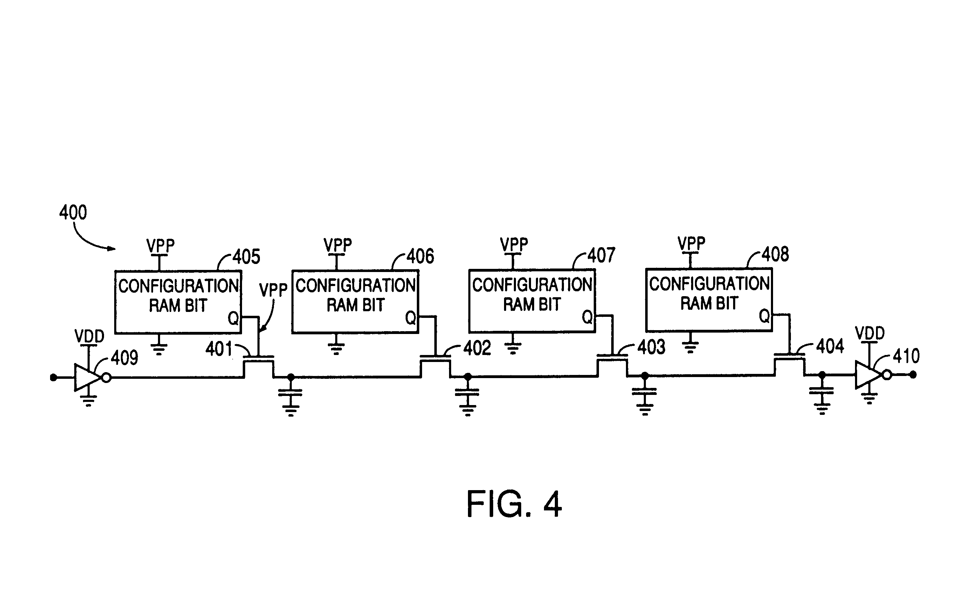

In accordance with the present invention, a voltage VPP is provided to the configuration RAM bits of a programmable logic device, so that the "logic high" voltage level in the output signal of the configuration RAM bits is at voltage VPP, which has higher voltage level than supply voltage VDD. Since each configuration RAM bit controls a switch transistor element in a programmable interconnect path, voltage VPP reduces the on-resistance of such switch transistor, thereby reduces performance degradation in the programmable interconnect path. The present invention is illustrated by way of example in the following description in conjunction with Figures 4-7. To simplify cross reference among the figures, analogous structures in these figures are provided the same reference numerals throughout.

Figure 4 shows an embodiment of the present invention in which voltage VPP is generated by MOS charge pumps on-chip, so as to eliminate the need for an external high voltage power supply. The programmable logic device of the present embodiment is implemented as a CMOS integrated circuit and operates in two modes: a) configuration or programming mode and b) operation mode. In the configuration or programming mode, the CMOS integrated circuit receives a program for configuring both the logic devices and the interconnection paths to implement a logic circuit. Thus configured, during operation mode, the CMOS integrated circuit performs the intended functions of the logic circuit.

During configuration mode, configuration bits are shifted into the programmable logic device to configure the programmable interconnect paths. The programmable interconnect paths thus configured provide the interconnection of the logic blocks of the programmable logic device during operation mode.

Voltage VPP is provided during operation mode to decrease the on-resistances of the programmable interconnect paths. In the present embodiment, during configuration mode, both the configuration RAM bits and the logic blocks operate at the supply voltage VDD, and voltage VPP is not used. It will be appreciated that because (i) the stored logic values in the configuration RAM bits are not changed during operation mode, and (ii) power is consumed in a CMOS circuit only when logic states are changed, the amount of current drawn from the circuit generating voltage VPP is minimal. Consequently, using voltage VPP in the present embodiment increases the programmable device's power consumption only by the negligible amount necessary for operating the MOS charge pump.

In the present embodiment, the configuration RAM bits comprise 250 columns of flip-flops organized into programmable switch elements. Each column offlip-flops stores 80-400 bits, depending on the size of the gate array circuit implemented in the programmable logic device. During configuration mode, the programmable interconnect paths are programmed column by column according to the content of a shift register dedicated for programming purpose. Column programming is accomplished by serially shifting 80-400 configuration bits, depending on the size of the gate array circuit implemented, into the shift register through a selected pin of the programmable logic device. When all of the 80-400 configuration bits are shifted into the shift register, these configuration bits are provided to the programmable interconnect paths in parallel to the programmable switch elements. When all 250 columns of configuration RAM bits are programmed, the programmable logic device enters operation mode.

As shown in Figure 4, a programmable interconnect path 400 connecting inverter409 to inverter 410 comprises switch transistors 401-404 controlled respectively by configuration RAM bits 405-408. Inverters 409 and 410 can be inverters within the same or a different logic block. In Figure 4, during operation mode, configuration RAM bits 405-408 are each provided voltage VPP, which is higher than supply voltage VDD provided to inverters 409 and 410. Voltage VPP used in this embodiment is approximately 7.5 volts, and supply voltage VDD, which is the external power supply voltage provided to the programmable logic device, is approximately 5 volts. Of course, these voltages are provided for example only, other combinations of VPP and VDD voltages can also be used, so long as voltage VPP is higher than supply voltage VDD.

As voltage VPP is higher than the supply voltage VDD, the on-resistance of a switch transistor biased at its gate terminal at voltage VPP is comparatively less than the on-resistance of such switch transistor biased at its gate terminal at voltage VDD. Thus, a programmable interconnect path comprising a number of such VPP-biased switch transistors connected in series will experience a reduction in total path resistance, thereby allowing a signal in the programmable interconnect path to have shorter rise and fall times. Consequently, with voltage VPP supplied to the configuration RAM bits to control the gate terminals of switch transistors, the performance degradation due to the number of switch transistors in a programmable interconnect path is reduced.

As this reduction of on-resistance in a switch transistor is achieved without requiring a shorter channel length or a wider channel width, neither circuit density manufacturing yield, nor cost is traded off to achieve this higher circuit performance.

It will be appreciated that, if the above integrated circuit is implemented in a CMOS process in which N-substrate and P-wells are used, e.g. the manufacturing process of the circuit discussed above in conjunction with Figure 3b, the PMOS transistors of the logic blocks (e.g. transistors of inverters 409 and 410) and the PMOS transistors in the configuration RAM bits (e.g. configuration RAM bits 405-409) cannot share the same connected N- substrate. The reason forthis incompatibility can be seen by inspecting prior art PMOS transistors 301c and 304b of Figure 3b. In Figure 3b, if the source terminal of PMOS transistor 301c c (which is a PMOS transistor of configuration RAM bit 301) is biased to the VPP voltage, a forward-biased junction is formed between the source terminal of transistor 301c and the N-substrate, which is biased by substrate contact 305 to the lower voltage VDD.

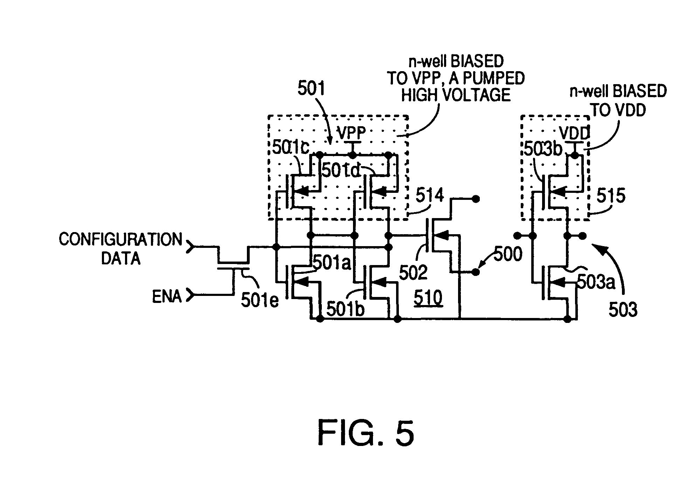

Therefore, to avoid a short circuit due to the forward-biased junction discussed above, the present embodiment uses a P- substrate and provides separate N-wells for the PMOS transistors of the logic circuit blocks and the programmable interconnect paths. To illustrate the effectiveness of this approach, Figure 5 shows devices at one connection point of programmable interconnect path 500 in the present embodiment.

As shown in Figure 5, configuration RAM bit 501 comprises PMOS transistors 501c and 501d, NMOS transistors 501a a and 501 b, and transfer gate 501 e, which is controlled by an enable signal ENA. The output signal of configuration RAM bit 501 controls the gate terminal of switch transistor 502, which is a switch transistor in one connection point of programmable interconnect path 500. Also shown in Figure 5 is inverter 503 of a logic circuit block. Inverter 503 comprises PMOS transistor 503b and NMOS transistor 503a. In Figure 5, PMOS transistors 501c and 501d are formed inside N-well 514, which is biased to voltage VPP. N-well 515, which is biased to supply voltage VDD and isolated from N-well 514, encloses PMOS transistor 503b of inverter 503. Since N-well 514 and N-well 515 are isolated by P- substrate 510, and P-substrate 510 is biased to ground voltage, no forward-biased junction can be formed between the N-well 514 (biased at voltage VPP) and the N-well 515 (biased at voltage VDD).

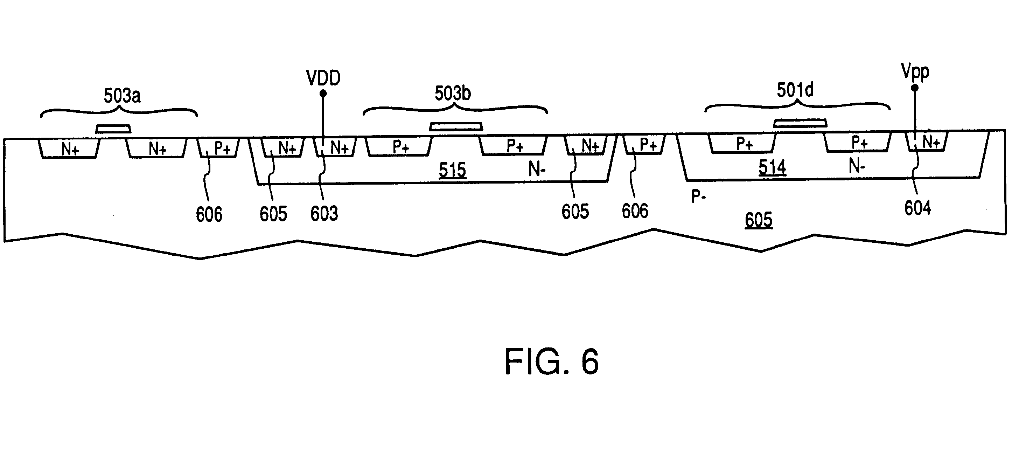

Figure 6 is an idealized cross section of an implementation of Figure 5's connection point of programmable interconnect path 500, showing in substrate 605 N-wells 514 and 515 enclosing respectively PMOS transistor 501d of the configuration RAM bit 501 and PMOS transistor 503b of inverter 503. As shown in Figure 6, N-well 514, which encloses PMOS transistor 501d of the RAM configuration bit 501, is biased to voltage VPP at contact 604. Isolated from N-well 514 and enclosing PMOS transistor 503b of inverter 503 of a logic block, N-well 515 is biased to the supply voltage VDD through contact 603. In this embodiment, N region 605 and P region 606 form annular double guard-bands structures to minimize the undesirable effects of any strong local electric fields.

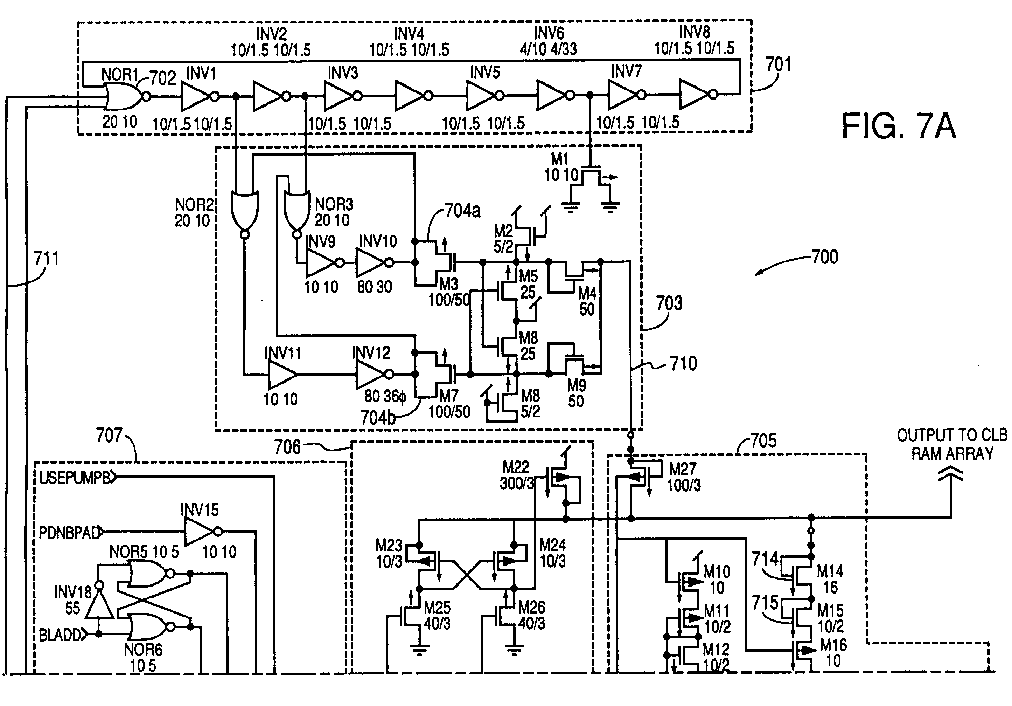

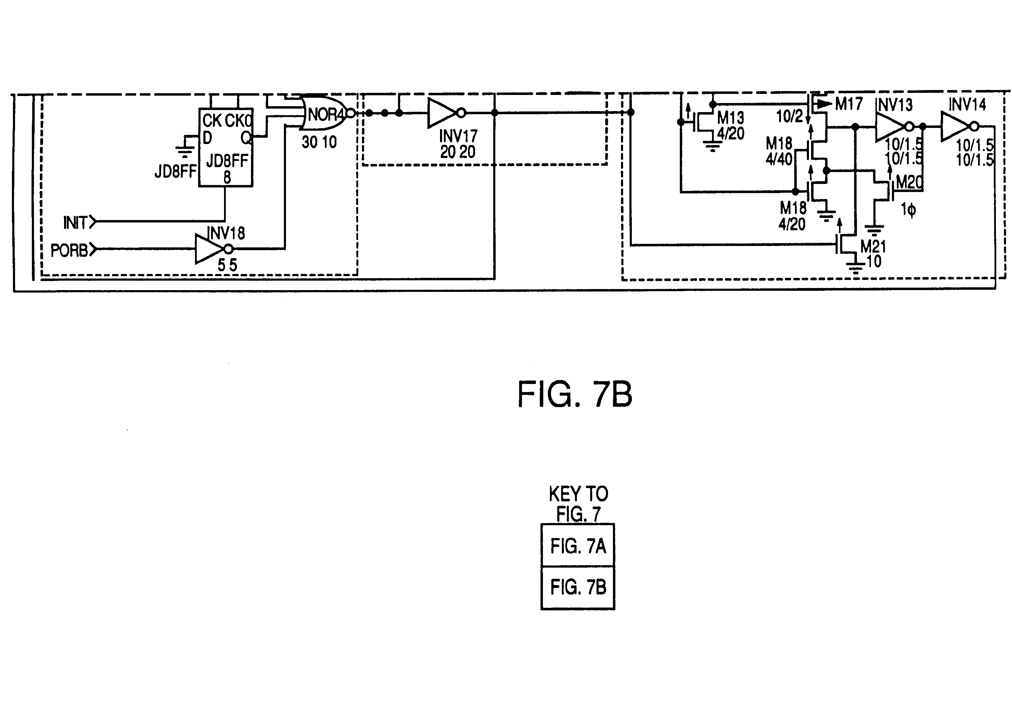

Voltage VPP of the present embodiment is generated on-chip using the supply voltage VDD. A suitable circuit 700 for generating and regulating voltage VPP in the present embodiment is shown in Figure 7. As shown in Figure 7, enabled by NOR gate 702, ring oscillator 701 provides voltage pulses to charge pump circuit 703. In charge pump circuit 703, the voltage pulses received from ring oscillator 701 are provided to MOS capacitors 704a and 704b to generate voltage VPP on lead 710.

In this embodiment, voltage regulator circuit 705 regulates generated voltage VPP by a signal provided on lead 711, which alternatively enables or disables the ring oscillator 701 through NOR gate 702. Voltage regulator circuit 705 limits the maximum voltage level of voltage VPP to approximately supply voltage VDD plus the sum of the threshold voltages of transistors 714 and 715. In this embodiment, supply voltage VDD is approximately 5 volts, and the threshold voltages of transistors 714 and 715 are set such that maximum voltage level of voltage VPP is approximately 7.5 volts.

When voltage VPP exceeds the target maximum voltage level, voltage regulator circuit 705 sets the voltage on lead 711 to logic high thereby disabling oscillation in the ring oscillator 701, which in turns disables the charge pump circuit 703. Ring oscillator 701, hence charge pump circuit 703, is reenabled when the voltage VPP falls below the target maximum voltage level. Reliability in the programmable logic device is enhanced by limiting the maximum voltage level attained by voltage VPP.

In the present embodiment, voltage VPP can be turned off at the user's option. When voltage VPP is turned off, in place of voltage VPP, supply voltage VDD is provided as the operating voltage for the configuration RAM bits. The mechanism for switching the operating voltage between voltage VPP and supply voltage VDD is provided by high voltage to low voltage converter 706, which is controlled by logic circuit 707.

In addition to the aforementioned user's option (indicated by the signal USEPUMPB), logic circuit 707 turns off voltage VPP under various other predetermined conditions, including when the programmable device is in the configuration mode (indicated by the signal BLADD), during power down (indicated by the signal PDNBPAD), and during system initialization (indicated by signal PORB).

As illustrated in Figure 7, ring oscillator 701, charge pump circuit 703, voltage regulator circuit 705, high voltage to low voltage converter 706 and logic circuit 707 are conventional circuits known in the art. Of course, these conventional circuits are provided for example only to illustrate one embodiment of the present invention. Each of these conventional circuits can be replaced by any suitable circuit providing an equivalent function.

The detailed description is provided above to illustrate the specific embodiments discussed, and not intended to limit the present invention. Many modifications and variations within the scope of the present invention are possible. For example, it is within the scope of the present invention to provide the voltage VPPfrom an external supply voltage, ratherthan generating voltage VPP on-chip. The present invention is defined by the following Claims.

## Claims

1. In an integrated circuit receiving a supply voltage, an apparatus for providing a programmable interconnect path between logic circuits comprising:
a plurality of switch means forforming said programmable interconnect path, each switch means receiving a control voltage and having first and second terminals, wherein said switch means causes said first and second terminals to be shorted and to be open according to whether said control voltage is in a higher voltage state or a low voltage state; and, for each switch means,
means for storing said control voltage, wherein, when said control voltage is in said high voltage state, said means for storing provides said control voltage at a voltage level higher than said supply voltage.

2. An apparatus as in Claim 1, further comprising means on said integrated circuit for generating the voltage level of said high voltage state.

3. An apparatus as in Claim 2, wherein said means for generating the voltage level of said high voltage state comprises:
an oscillator providing voltage pulses; and means, receiving said voltage pulses, for driving charge pumping in a plurality of MOS capacitors.

4. An apparatus as in Claim 2, further comprising means for regulating said voltage level of said high voltage state, said voltage regulating means limiting said voltage level to a predetermined value above said supply voltage.

5. An apparatus as in Claim 1, further comprising means for disabling said higher voltage level, said means for disabling said higher voltage level, when activated, causes said control voltage to be provided at the same voltage level as said supply voltage.

6. In an integrated circuit receiving a supply voltage, a method for providing a programmable interconnect path between logic circuits, comprising the steps of:
forming said programmable interconnect path using a plurality of switch means, each switch means receiving a control voltage and having first and second terminals, wherein said switch means causes said first and second terminals to be shorted and to be open according to whethersaid control voltage is in a higher voltage state or a low voltage state; and, for each switch means,
providing said control voltage such that when said control voltage is in said high voltage state, said control voltage is at a voltage level higher than said supply voltage.

7. A method as in Claim 6, further comprising the step of generating the voltage level of said high voltage state on said integrated circuit.

8. A method as in Claim 6, wherein said step of generating the voltage level of said high voltage state comprises the steps of:
providing oscillating voltage pulses; and receiving said voltage pulses to drive charge pumping in a plurality of MOS capacitors.

9. A method as in Claim 7, further comprising the step of regulating said voltage level of said high voltage state, said regulating step limiting said voltage level to a predetermined value above said supply voltage.

10. A method as in Claim 6, further comprising the step of disabling said higher voltage level in accordance with a selection signal, so as to allow selecting said control signal to be at the same voltage level as said supply voltage.
